(19) Europäisches Patentamt / European Patent Office / Office européen des brevets

(11) **EP 2 975 720 B1**

(12) **EUROPEAN PATENT SPECIFICATION**

(45) Date of publication and mention
of the grant of the patent:
**29.06.2022 Bulletin 2022/26**

(21) Application number: **15174370.5**

(22) Date of filing: **29.06.2015**

(51) International Patent Classification (IPC):
*H02H 7/20* (2006.01)  *G01R 27/18* (2006.01)

(52) Cooperative Patent Classification (CPC):
**G01R 27/18; G01R 31/52**

(54) **DEVICE AND METHOD FOR DETECTING INSULATION OF PHOTOVOLTAIC MODULES AGAINST GROUND AND PHOTOVOLTAIC GRID-CONNECTED POWER GENERATION SYSTEM**

VORRICHTUNG UND VERFAHREN ZUR ERKENNUNG DER ISOLIERUNG VON PHOTOVOLTAIKMODULEN GEGEN MASSE UND NETZGEKOPPELTES PHOTOVOLTAISCHES ENERGIEERZEUGUNGSSYSTEM

DISPOSITIF ET PROCÉDÉ DE DÉTECTION D'ISOLATION DE MODULES PHOTOVOLTAÏQUES CONTRE LA MASSE ET SYSTÈME DE GÉNÉRATION DE PUISSANCE PHOTOVOLTAÏQUE RACCORDÉ AU RÉSEAU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2014 CN 201410308829**

(43) Date of publication of application:
**20.01.2016 Bulletin 2016/03**

(73) Proprietor: **Sungrow Power Supply Co., Ltd.**
**Hefei, Anhui 230088 (CN)**

(72) Inventors:
• **LI, Xiaoxun**
**230088 Hefei (CN)**
• **LI, Haoyuan**
**230088 Hefei (CN)**
• **MEI, Xiaodong**
**230088 Hefei (CN)**
• **HAN, Zhiqiang**
**230088 Hefei (CN)**
• **WU, Touming**
**230088 Hefei (CN)**
• **HE, Chao**
**230088 Hefei (CN)**
• **SONG, Yang**
**230088 Hefei (CN)**

(74) Representative: **Brevalex**
**95, rue d'Amsterdam**
**75378 Paris Cedex 8 (FR)**

(56) References cited:
WO-A1-2012/120683   CN-A- 102 967 766
CN-U- 203 037 745   US-A1- 2013 272 039

## Description

### FIELD

The present disclosure relates to the technical field of photovoltaic power supply, and in particular to a device and method for detecting insulation of photovoltaic modules against ground and a photovoltaic grid-connected power generation system.

### BACKGROUND

The photovoltaic grid-connected power generation system converts direct current output from a solar battery into alternating current having the same frequency and the same phase as the grid voltage, which can supply power for a load and also transmit electric energy to the grid. A photovoltaic inverter is an important component of the photovoltaic grid-connected power generation system.

In order to ensure safety and stability of the photovoltaic grid-connected power generation system, it is required to detect insulation impedance of photovoltaic modules against ground before the photovoltaic modules are connected to grid.

In the conventional detection circuit for detecting the insulation impedance of photovoltaic modules against ground, the insulation of the photovoltaic modules against ground is detected by assuming that a ground wire of the photovoltaic inverter and a zero line of the grid each are grounded effectively. Once either of the ground wire of the photovoltaic inverter or the zero line of the grid is not grounded effectively, the conventional detection circuit can not detect whether the abnormity of connection to ground is due to the abnormity of the connection of the ground wire of the photovoltaic inverter or the zero line of the grid to ground, or due to the abnormity of the insulation of the photovoltaic modules against ground. Thus, the detection result of the insulation of the photovoltaic modules against ground is not reliable.

A patent application CN102967766A discloses a non-switch-tube detection system and method for ground insulation resistance of the dual-path photovoltaic inverter. Three equations which only include three unknown quantities, namely insulating resistance R1+, insulating resistance R2+ and insulating resistance R-, can be obtained by controlling short circuit/open circuit of two paths of photovoltaic cells in a detection process, and meanwhile, a resistance value between each two bridge arms also changes by virtue of the one-way conduction property of a diode when the voltage of the two paths of photovoltaic cells changes. Therefore, the three equations are independent from one another, namely each required insulating resistance can be obtained by solving the three equations. The detection system and method utilize the one-way conduction property of the diode to change the resistance value between each two bridge arms and do not need a switch tube, and therefore, the cost of the detection system and the size of the inverter are effectively reduced.

A patent application WO2012120683A1 discloses an insulation resistance detection circuit. In particular, a CPU calculates an insulation resistance value of a direct current power supply using: a first current value, which is measured on the basis of a voltage (first measured voltage) measured by means of a divided voltage measuring circuit, and on a current (first grounding current) measured by means of a current measuring circuit, said voltage and said current having been measured when a switch is opened; and a second current value, which is measured on the basis of a voltage (second measured voltage) measured by means of the divided voltage measuring circuit, and a current (second grounding current) measured by means of the current measuring circuit, said voltage and said current having been measured when the switch is closed. Time intervals, at which the switch is opened and closed, said time intervals determining measuring times for measuring the first and the second current values, are variably set, corresponding to a change quantity between the first and the second grounding currents measured by means of the current measuring circuit.

### SUMMARY

In order to solve the above technical problems, a detection device and method for detecting insulation of a photovoltaic module against ground and a photovoltaic grid-connected power generation system are provided according to the claims, thereby ensuring reliability of the insulation detection of the photovoltaic module against ground.

In order to achieve the above object, technical solutions are provided according to the present disclosure hereinafter.

A detection device for detecting insulation of a photovoltaic module against ground is provided according to claim 1.

Preferably, the detection device may further include a protective resistor, where the protective resistor is arranged between the common node and the second switching device.

Preferably, in the detection device, the second switching device may include a first sub-switch and a second sub-switch, where the first sub-switch is configured to control the connection of the common node and the ground wire, and the second sub-switch is configured to control the connection of the common node and the zero line.

Preferably, in the detection device, the first sub-switch may be a transistor switch, a mechanical electric switch or a relay, and the second sub-switch may be a transistor switch, a mechanical electric switch or a relay.

Preferably, in the detection device, the second switching device may be a two-position knob switch or a double-pole double-throw switch.

Preferably, in the detection device, the first switching device may be a transistor switch, a mechanical switch or a relay.

A detection method for detecting insulation of a photovoltaic module against ground is provided according to the present disclosure, where the detection device described above is adopted to detect insulation of the photovoltaic module against ground, and the detection method includes:

connecting the common node with the ground wire, and disconnecting the zero line from the common node;

obtaining a first node voltage of the common node and a first positive voltage of the positive terminal when the first switching device is open, and obtaining a second node voltage of the common node and a second positive electrode voltage of the positive terminal when the first switching device is closed;

calculating a first test value of the resistor of the positive terminal relative to ground and a first test value of the resistor of the negative terminal relative to ground based on the first node voltage, the first positive voltage, the second node voltage and the second positive voltage;

disconnecting the ground wire from the common node, and connecting the common node with the ground wire;

obtaining a third node voltage of the common node and a third positive voltage of the positive terminal when the first switching device is open, and obtaining a fourth node voltage of the common node and a fourth positive voltage of the positive terminal when the first switching device is closed;

calculating a second test value of the resistor of the positive terminal relative to ground and a second test value of the resistor of the negative terminal relative to ground based on the third node voltage, the third positive voltage, the fourth node voltage and the fourth positive voltage;

determining that the ground wire and the zero line each are grounded effectively, in the case that an absolute value of a difference between the first test value and the second test value of the resistor of the positive terminal relative to ground is less than a first threshold and an absolute value of a difference between the first test value and the second value of the resistor between the negative terminal and ground is less than the first threshold; and

determining whether the first test value and the second test value of the resistor of the positive terminal relative to ground each are greater than a second threshold, in the case that the ground wire and the zero line each are grounded effectively; and determining that the photovoltaic module is normally insulated against ground, if it is determined that the first test value and the second test value of the resistor of the positive terminal relative to ground each are greater than the second threshold; otherwise, determining that the photovoltaic module is abnormally insulated against ground.

Preferably, in the detection method, the first threshold may be less than or equal to 200Ω.

Preferably, in the detection method, the second threshold may be greater than or equal to 1KΩ.

A photovoltaic grid-connected power generation system is further provided according to the present disclosure, which includes at least one detection device for detecting insulation of a photovoltaic module against ground described above.

According to the above technical solutions, the detection device for detecting insulation of a photovoltaic module against ground provided by the present disclosure can test voltage values of the common node and the positive terminal in different switching states of the first switching device and the second switching device.

With the detection method, in the case that the common node is connected with the ground wire and the zero line is disconnected from the common node, respective test values of the resistor of the positive terminal relative to ground and the resistor of the negative terminal relative to ground may be calculated when the first switching device is open or the first switching device is closed, and it may be determined whether the ground wire and the zero line each are grounded effectively based on the test values of the resistor of the positive terminal relative to ground and the resistor of the negative terminal relative to ground. In the case that the ground wire and the zero line each are grounded effectively, it may be further determined whether the insulation of the photovoltaic module against ground is normal based on the test value of the resistor of the positive terminal relative to ground in case of the first switching device being open and the test value of the resistor of the positive terminal relative to ground in case of the first switching device being closed.

With the detection device and the detection method, it may be detected whether the ground wire and the zero line each are grounded effectively, and it may be further determined whether the insulation of the photovoltaic module against ground is normal in the case that the ground wire and the zero line each are grounded effectively. It follows that the detection device and the detection method ensure reliability of insulation detection of the photovoltaic module against ground. A photovoltaic grid-connected power generation system including the detection device is further provided according to the present disclosure, which may be used to detect insulation of a photovoltaic module against ground, and thereby ensuring reliability of a detection result and reducing a cost of the photovoltaic grid-connected power generation system.

## BRIEF DESCRIPTION OF THE DRAWINGS

In order to illustrate technical solutions in embodiments of the present disclosure or the conventional technology more clearly, hereinafter drawings to be used in the description of the embodiments or the conventional technology will be introduced simply. Apparently, the drawings described below only describe the embodiments of present disclosure. Other drawings may also be obtained according to the provided drawings by those skilled in the art without any creative work.

Figure 1 is a schematic structural diagram of a detection device for detecting insulation of a photovoltaic device against ground according to an embodiment of the present disclosure;

Figure 2 is a schematic structural diagram of a detection device for detecting insulation of a photovoltaic module against ground according to another embodiment of the present disclosure;

Figure 3 is a schematic structural diagram of a photovoltaic grid-connected power generation system according to the present disclosure;

Figure 4 is a schematic structural diagram of another photovoltaic grid-connected power generation system according to the present disclosure; and

Figure 5 is a schematic structural diagram of still another photovoltaic grid-connected power generation system according to the present disclosure.

## DETAILED DESCRIPTION OF THE EMBODIMENTS

Hereinafter technical solutions of embodiments of the present disclosure are described clearly and completely in conjunction with the drawings of the embodiments of the present disclosure. Any other embodiments obtained based on the embodiments of the present disclosure by those skilled in the art without any creative work fall within the scope of protection of the present invention.

As described in the background, the conventional detection circuit can not detect whether the abnormity of connection to ground is due to the abnormity of the connection of the ground wire of the photovoltaic inverter or the zero line of the grid to ground, or due to the abnormity of the insulation of the photovoltaic modules against ground. Thus, the detection result of the insulation of the photovoltaic modules against ground is unreliable.

If the zero line is not grounded effectively, there may be an electric shock risk when detecting the photovoltaic module; and in addition if the ground wire is not grounded effectively, a leakage protection circuit of the photovoltaic inverter can not work normally, thereby causing danger to an operator.

Therefore, when detecting insulation of the photovoltaic module in a photovoltaic grid-connected power generation system against ground, firstly it is detected whether the ground wire of the photovoltaic inverter and the zero line of the grid are grounded effectively; and the insulation of the photovoltaic module against ground is detected in the case that it is determined that the ground wire and the zero line are grounded effectively.

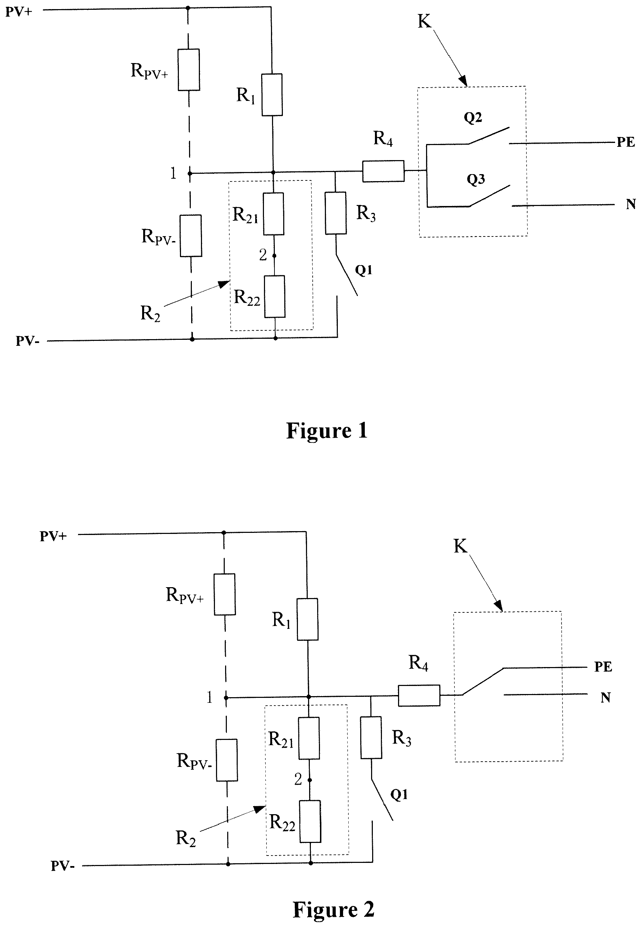

Based on the above analysis, a detection device for detecting insulation of a photovoltaic module against ground is provided according to an embodiment of the present disclosure. Referring to Figure 1, the detection device includes a first test resistor $R_1$, a second test resistor $R_2$, a third test resistor $R_3$, a first switching device $Q_1$ and a second switching device K.

The first test resistor $R_1$ is connected in parallel to a resistor $R_{pv+}$ of a positive terminal of the photovoltaic module relative to ground. The second test resistor $R_2$ is connected in parallel to a resistor $R_{pv-}$ of a negative terminal of the photovoltaic module relative to ground. One end of the second test resistor $R_2$ is connected to the negative terminal PV- of the photovoltaic module, and the other end of the second test resistor $R_2$ is connected to the positive terminal PV+ of the photovoltaic module via the first test resistor $R_1$. The first test resistor $R_1$ and the second test resistor $R_2$ share a common node 1.

The third test resistor $R_3$ is connected to the first switching device $Q_1$ in series to form a series branch, and the series branch is connected to the second test resistor $R_2$ in parallel. Alternatively, the series branch may be connected to the first test resistor $R_1$ in parallel. The position relation between the third test resistor $R_3$ and the first switching device $Q_1$ in the series branch is not limited. The third test resistor $R_3$ may be closer to the common node 1, or the first switching device $Q_1$ may be closer to the common node 1.

The second switching device K has a first switching state in which the connection of the common node 1 and a ground wire PE of a photovoltaic inverter is controlled, and a second switching state in which the connection of the common node 1 and a zero line N of a grid is controlled.

As shown in Figure 1, the second switching device K may include a first sub-switch $Q_2$ and a second sub-switch $Q_3$. The first sub-switch $Q_2$ is configured to control the connection of the common node 1 and the ground wire PE; and the second sub-switch $Q_3$ is configured to control the connection of the common node 1 and the zero line N. The first sub-switch $Q_2$ may be a transistor switch, a mechanical electric switch or a relay; and the second sub-switch $Q_3$ may be a transistor switch, a mechanical electric switch or a relay.

As shown in Figure 2, the second switching device K may also be a two-position knob switch or a double-pole double-throw switch.

In order to prevent electronics of the detection device from being damaged by too high current, the detection device further includes a protective resistor $R_4$. The protective resistor $R_4$ is arranged between the common node 1 and the second switching device K.

The first test resistor $R_1$, the second test resistor $R_2$ and the third test resistor $R_3$ may be embodied in many forms. They each may be one resistor element or multiple resistor elements connected in series. As shown in Figure 1 and Figure 2, the second test resistor $R_2$ includes two test resistors $R_{21}$ and $R_{22}$ connected in series. Alternatively the second test resistor $R_2$ may be composed of only one resistor element. In the case that the second test resistor R2 is composed of two series-connected test resistors, the test resistor $R_{21}$ and the test resistor $R_{22}$ share a common node 2; in this case, a voltage of the common node 1 may be obtained by directly detecting the voltage at the common node 1 or by making a calculation based on a detected voltage at the common node 2 and a voltage division ratio between the test resistor $R_{21}$ and the test resistor $R_{22}$.

The voltage values of the common node 1 and the positive terminal obtained in different combinations of the first switching device and the second switching device may be used to obtain the test values of the resistor of the positive terminal relative to ground and the resistor of the negative terminal relative to ground. Therefore, the detection device may be used to measure the resistor of the positive terminal relative to ground and the resistor of the negative terminal relative to ground.

According to another embodiment of the present disclosure, a detection method for detecting insulation of a photovoltaic module against ground is provided, where the detection device described above is adopted to perform the detection of insulation of a photovoltaic module against ground. The detection method includes step S11 to step S18.

In step S11, the common node 1 is connected with the ground wire PE, and the zero line N is disconnected from the common node 1.

The state of the second switching device K may be controlled such that the common node 1 is connected with the ground wire PE, and the zero line N is disconnected from the common node 1.

In step S12, when the first switching device Q1 is open, a first node voltage $U_1$ of the common node 1 and a first positive voltage $U_{PV1}$ of the positive terminal PV+ are obtained. When the first switching device Q1 is closed, a second node voltage U2 of the common node 1 and a second positive voltage $U_{PV2}$ of the positive terminal PV+ are obtained.

The voltages of the common node 1 and the positive terminal PV+ may be obtained directly via a voltage testing device, thereby the first node voltage U1, the second node voltage U2, the first positive voltage $U_{PV1}$ and the second positive voltage $U_{PV2}$ are obtained. In the case that the second test resistor $R_2$ is composed of two test resistors, a voltage of the common node 2 may be obtained via a voltage testing device, and then a voltage division calculation may be carried out to obtain the first node voltage $U_1$ and the second node voltage $U_2$ of the common node 1.

In step S13, a first test value $R_{1X}$ of the resistor $R_{PV+}$ of the positive terminal relative to ground and a first test value $R_{2X}$ of the resistor $R_{PV-}$ of the negative terminal relative to ground are calculated based on the first node voltage $U_1$, the first positive voltage $U_{PV1}$, the second node voltage $U_2$ and the second positive voltage $U_{PV2}$.

According to the kirchhoff's law, in the case that the first switching device $Q_1$ is open, the following equation (1) is met:

$$\frac{U_{PV1}-U_1}{R_1}+\frac{U_{PV1}-U_1}{R_{1x}}=\frac{U_1}{R_2}+\frac{U_1}{R_{2x}} \qquad (1);$$

and in the case that the first switching device $Q_1$ is closed, the following equation (2) is met:

$$\frac{U_{PV2}-U_2}{R_1}+\frac{U_{PV2}-U_2}{R_{1x}}=\frac{U_2}{R_2}+\frac{U_2}{R_{2x}}+\frac{U_2}{R_3} \qquad (2).$$

In equations (1) and (2), the first test resistance R1, the second test resistance R2 and the third test resistance R3 are known, and they are constants. The first test value $R_{1X}$ and the first test value $R_{2X}$ may be obtained by solving the equation group composed of equations (1) and (2).

It should be noted that, in the embodiments of the present disclosure, the voltage of the negative terminal PV- is set as a reference potential which is zero.

In step S14, the ground wire PE is disconnected from the common node 1, and the common node 1 is connected with the zero line N.

Similarly, the state of the second switching device K may be controlled such that the ground wire PE is disconnected from the common node 1, and the common node 1 is connected with the zero line N.

In step S15, a third node voltage $U_3$ of the common node 1 and a third positive voltage $U_{PV3}$ of the positive terminal PV+ are obtained when the first switching device Q1 is open; and a fourth node voltage $U_4$ of the common node 1 and a fourth positive voltage $U_{PV4}$ of the positive terminal PV+ are obtained when the first switching device Q1 is closed.

The ways to obtain the third node voltage $U_3$, the fourth node voltage $U_4$, the third positive voltage $U_{PV3}$ and the fourth positive voltage $U_{PV4}$, are similar to those for obtaining the first node voltage $U_1$, the second node voltage $U_2$, the first positive voltage $U_{PV1}$ and the second positive voltage $U_{PV2}$, which are not described detailed here.

In step S16, a second test value $R_{1y}$ of the resistor $R_{pv+}$ of the positive terminal relative to ground and a second test value $R_{2y}$ of the resistor $R_{pv-}$ of the negative terminal relative to ground are calculated based on the third node voltage $U_3$, the third positive voltage $U_{pv3}$, the fourth node voltage $U_4$ and the fourth positive voltage $U_{pv4}$.

Similarly, in the case that the first switching device Q1 is open, the following equation (3) is met:

$$\frac{U_{PV3}-U_3}{R_1}+\frac{U_{PV3}-U_3}{R_{1y}}=\frac{U_3}{R_2}+\frac{U_3}{R_{2y}} \qquad (3);$$

and in the case that the first switching device Q1 is closed, the following equation (4) is met:

$$\frac{U_{PV4}-U_4}{R_1}+\frac{U_{PV4}-U_4}{R_{1y}}=\frac{U_4}{R_2}+\frac{U_4}{R_{2y}}+\frac{U_4}{R_3} \qquad (4)$$

In equations (3) and (4), the first test resistance $R_1$, the second test resistance $R_2$ and the third test resistance $R_3$ are known, and they are constants. The second test value $R_{1y}$ and the second test value $R_{2y}$ may be obtained by solving the equation group composed of equations (3) and (4).

In step S17, it is determined that the ground wire PE and the zero line N each are grounded effectively, in the case that an absolute value $\triangle1$ of a difference between the first test value $R_{1x}$ and the second test value $R_{1y}$ of the resistor $R_{pv+}$ of the positive terminal relative to ground is less than a first threshold, and an absolute value $\triangle2$ of a difference between the first test value $R_{2x}$ and the second test value $R_{2y}$ of the resistor $R_{PV-}$ of the negative terminal relative to ground is less than the first threshold.

Here, $\triangle1=|R_{1x}-R_{1y}|$, $\triangle2=|R_{2x}-R_{2y}|$. If the ground wire PE and the zero line N each are grounded effectively, two test values of the resistor $R_{PV+}$ of the positive terminal relative to ground should be equal theoretically, i.e., the difference between the first test value $R_{1x}$ and the second test value $R_{1y}$ is zero; and similarly, two test values of the resistor $R_{PV-}$ of the negative terminal relative to ground should be equal, i.e., the difference between the first test value $R_{2x}$ and the second test value $R_{2y}$ is zero. However, due to the differences of contact resistances in the circuit and measuring errors, the two test values of the resistor $R_{PV+}$ of the positive terminal relative to ground may be unequal and the two test values of the resistor $R_{PV-}$ of the negative terminal relative to ground may also be unequal, hence the first threshold is set. In the embodiment, the first threshold is set to be less than or equal to, for example, 200Ω. In the case that the absolute values of the differences are less than or equal to the first threshold, it may be determined that the ground wire PE and the zero line N each are grounded effectively.

If at least one of △1 and △2 is not less than the threshold, it may be determined that at least one of the ground wire PE and the zero line N is not grounded effectively, i.e. being grounded abnormally. In this case, ground detection may be performed on the ground wire and the zero line to remove a ground fault.

In step S18, it is determined whether the first test value $R_{1x}$ and the second test value $R_{1y}$ of the resistor $R_{pv+}$ of the positive terminal relative to ground each are greater than a second threshold, in the case that the ground wire PE and the zero line N each are grounded effectively. It is determined that the insulation of the photovoltaic module against ground is normal, if the first test value $R_{1x}$ and the second test value $R_{1y}$ of the resistor $R_{pv+}$ of the positive terminal relative to ground each are greater than the second threshold; otherwise, it is determined that the insulation of the photovoltaic module against ground is abnormal.

The voltage of the negative terminal PV- is set as a reference potential, which is zero, hence the insulation of the photovoltaic module against ground may be determined only based on the first test value $R_{1x}$ and the second test value $R_{1y}$ of the resistor $R_{pv+}$ of the positive terminal relative to ground.

If the insulation of the photovoltaic module against ground is normal, i.e., the positive terminal PV+ is insulated from ground, the obtained test value of the resistor $R_{PV+}$ of the positive terminal relative to ground will be a large resistance, hence a second threshold is set. In the embodiment, the second threshold is greater than or equal to, for example, 1KΩ. Within a range of the second threshold, it may be determined that the insulation of the photovoltaic module against ground is normal.

It should be noted that, the second threshold and the first threshold may be adjusted in a predetermined range based on different photovoltaic modules and photovoltaic grid-connected power generation systems.

The above detection method is illustrated by assuming that the series branch of the third detection resistor R3 and the first switching device Q1 is connected to the second detection resistor R2 in parallel. It also applied to the case that the series branch is connected to the first test resistor R1 in parallel. For example, the test values of the resistor $R_{PV-}$ of the negative terminal relative to ground and the resistor $R_{pv+}$ of the positive terminal relative to ground may also be calculated based on the kirchhoff's law, adopting the same switch adjusting way, which are not described detailed here.

Alternatively, in performing the detection method for detecting insulation against ground according to the present disclosure, step S14 to step S16 may be performed firstly, then step S11 to step S13 are performed, and lastly step S17 to step S18 are performed.

According to the above description, with the detection device and the detection method provided by the embodiments of the present disclosure, it may be detected whether the ground wire and the zero line each are ground effectively; and it may be further determined whether the insulation of the photovoltaic module against ground is normal, in the case that the ground wire and the zero line each are grounded effectively. It follows that the detection device and the detection method ensures reliability of the insulation detection for the photovoltaic module against ground.

A photovoltaic grid-connected power generation system is further provided according to another embodiment of the present disclosure, which includes the detection device for detecting insulation of a photovoltaic module against ground according to at least one of the above embodiments.

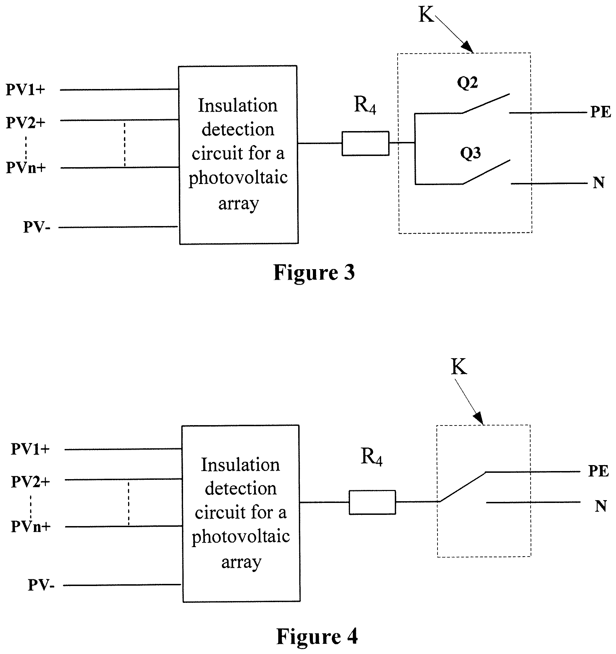

In the case that the photovoltaic grid-connected power generation system includes multiple photovoltaic modules, as shown in figures 3 and 4, the protective resistor R4 and the second switching device K are shared by the photovoltaic modules, and the negative terminal PV- is also shared by the photovoltaic modules.

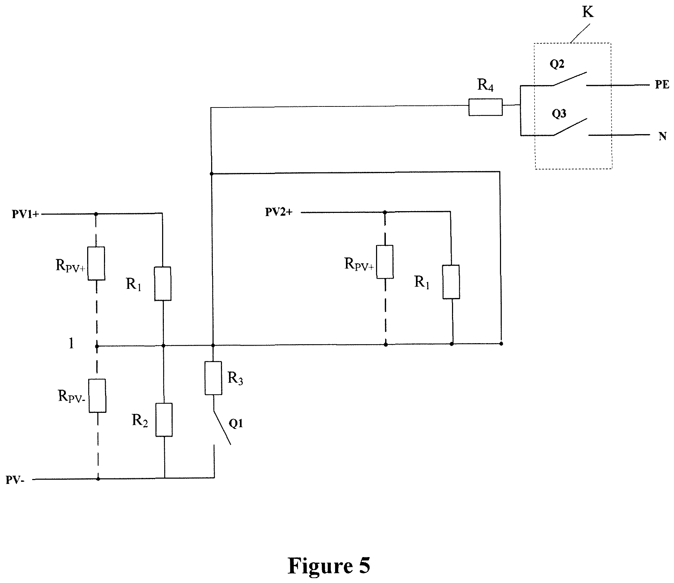

Referring to Figure 5, for the photovoltaic grid-connected power generation system including multiple photovoltaic modules, in order to reduce the cost, the photovoltaic grid-connected power generation system may include only one detection device described above, and only one first detection resistor R1 is provided for other photovoltaic modules, and the second detection resistor R2 corresponding to the resistor of the negative terminal relative to ground and the series branch may be shared. It should be noted that, in Figure 5 the photovoltaic grid-connected power generation system includes two photovoltaic modules as an example, and in practice the photovoltaic grid-connected power generation system may include more than two photovoltaic modules.

It follows that, the photovoltaic grid-connected power generation system includes multiple detection devices for detecting insulation of photovoltaic modules against ground, and the multiple detection devices share the negative terminal and the second switching device, thereby reducing the number of circuit devices and reducing the cost. The insulation of each of the multiple photovoltaic modules in the photovoltaic grid-connected power generation system against ground may be detected independently adopting the above detection method.

It should be noted that, in case of detecting insulation of a photovoltaic module against ground adopting the detection device according to the present disclosure, the test values of the resistor $R_{pv+}$ of the positive terminal relative to ground and the resistor $R_{pv-}$ of the negative terminal relative to ground may be calculated manually, and it is determined whether the ground wire PE and the zero line N each are grounded effectively and whether the insulation of the photovoltaic module against ground is normal based on the calculated result. Alternatively, a control system may be provided; the control system is configured to automatically calculate respective test values of the resistor $R_{pv+}$ of the positive terminal relative to ground and the resistor $R_{pv-}$ of the negative terminal relative to ground based on voltage values of the common node 1 and the positive terminal PV+ in different switching states of the first switching device Q1 and the second switching device K; automatically determine whether the ground wire PE and the zero line N each are grounded effectively based on the calculated result; send an alarm in the case that at least one of the ground wire PE and the zero line N is not grounded effectively; determine whether the insulation of the photovoltaic module against ground is normal based on the test values of the $R_{PV+}$ of the positive terminal relative to ground, in the case that the ground wire PE and the zero line N each are grounded effectively; and send an alarm in the case that the insulation against ground is abnormal.

According to the above illustration of the disclosed embodiments, those skilled in the art can implement or practice the present disclosure. Many changes to these embodiments are apparent for those skilled in the art, and general principles defined herein may be implemented in other embodiments without departing from the scope of the present disclosure. Hence, the present disclosure it not limited to the embodiments disclosed herein, but is to conform to the widest scope in accordance with principles and novel features disclosed herein.

**Claims**

1. A detection device for detecting insulation of a photovoltaic module against ground, **characterized in** comprising:

a first test resistor ($R_1$), wherein the first test resistor ($R_1$) is connectable in parallel to a resistor ($R_{PV+}$) of a positive terminal (PV+) of the photovoltaic module relative to ground;
a second test resistor ($R_2$), wherein the second test resistor ($R_2$) is connectable in parallel to a resistor ($R_{PV-}$) of a negative terminal (PV-) of the photovoltaic module relative to ground, and one end of the second test resistor ($R_2$) is connectable to the negative terminal (PV-), and the other end of the second test resistor ($R_2$) is connectable to the positive terminal (PV+) via the first test resistor ($R_1$);
a series branch of a third test resistor ($R_3$) and a first switching device ($Q_1$) connected in series, wherein the series branch is connected to the first or second test resistor ($R_1$, $R_2$) in parallel;
a second switching device (K), wherein the second switching device (K) has a first switching state in which a common node (1) between the first test resistor ($R_1$) and the second test resistor ($R_2$) is connected/disconnected with/from a ground wire (PE) of a photovoltaic inverter, and a second switching state in which the common node (1) is connected/disconnected with/from a zero line (N) of a grid; and
a control system configured to:

connect the common node (1) with the ground wire (PE), and disconnect the zero line (N) from the common node (1);
obtain a first node voltage of the common node (1) and a first positive voltage of the positive terminal (PV+) when the first switching device (Q1) is open, and obtain a second node voltage of the common node (1) and a second positive voltage of the positive terminal (PV+) when the first switching device (Q1) is closed;
calculate a first test value of the resistor ($R_{PV+}$) of the positive terminal (PV+) relative to ground and a first test value of the resistor ($R_{PV-}$) of the negative terminal (PV-) relative to ground based on the first node voltage, the first positive voltage, the second node voltage and the second positive voltage;
disconnect the ground wire (PE) from the common node (1), and connect the common node (1) with the zero line (N);
obtain a third node voltage of the common node (1) and a third positive voltage of the positive terminal (PV+) when the first switching device (Q1) is open, and obtain a fourth node voltage of the common node (1) and a fourth positive voltage of the positive terminal (PV+) when the first switching device (Q1) is closed;
calculate a second test value of the resistor ($R_{PV+}$) of the positive terminal (PV+) relative to ground and a second test value of the resistor ($R_{PV-}$) of the negative terminal (PV-) relative to ground based on the third node voltage, the third positive voltage, the fourth node voltage and the fourth positive voltage;
determine that the ground wire (PE) and the zero line (N) each are grounded effectively, in the case that an absolute value of a difference between the first test value and the second test value of the resistor ($R_{PV+}$) of the positive terminal (PV+) relative to ground is less than a first threshold and an absolute value of a difference between the first test value and the second value of the resistor ($R_{PV-}$) of the negative terminal (PV-) relative to ground is less than the first threshold; and
determine whether the first test value and the second test value of the resistor ($R_{PV+}$) of the positive terminal (PV+) relative to ground each are greater than a second threshold, in the case that the ground wire (PE) and the zero line (N) each are grounded effectively; and determining that the photovoltaic module is normally insulated against ground, if it is determined that the first test value and the second test value of the resistor ($R_{PV+}$) of the positive terminal (PV+) relative to ground each are greater than the second threshold; determining that the photovoltaic module is abnormally insulated against ground if it is determined that the first test value or the second test value of the resistor ($R_{PV+}$) of the positive terminal (PV+) relative to ground is not greater than the second threshold.

2. The detection device according to claim 1, further comprising a protective resistor ($R_4$), wherein the protective resistor ($R_4$) is arranged between the common node (1) and the second switching device (K).

3. The detection device according to claim 1, wherein the second switching device (K) comprises a first sub-switch ($Q_2$) and a second sub-switch ($Q_3$),
wherein the first sub-switch ($Q_2$) is configured to control the connection of the common node (1) and the ground wire (PE), and the second sub-switch ($Q_3$) is configured to control the connection of the common node (1) and the zero line (N).

4. The detection device according to claim 3, wherein the first sub-switch ($Q_2$) is a transistor switch, a mechanical electric switch or a relay, and the second sub-switch ($Q_3$) is a transistor switch, a mechanical electric switch or a relay.

5. The detection device according to claim 1, wherein the second switching device (K) is a two-position knob switch or a double-pole double-throw switch.

6. The detection device according to any one of claims 1 to 5, wherein the first switching device ($Q_1$) is a transistor switch, a mechanical switch or a relay.

7. A detection method for detecting insulation of a photovoltaic module against ground, **characterized in that** the detection device according to any one of claims 1 to 6 is adopted to detect insulation of the photovoltaic module against ground, and the detection method comprises:

connecting the common node (1) with the ground wire (PE), and disconnecting the zero line (N) from the common node (1);
obtaining a first node voltage of the common node (1) and a first positive voltage of the positive terminal (PV+) when the first switching device ($Q_1$) is open, and obtaining a second node voltage of the common node (1) and a second positive voltage of the positive terminal (PV+) when the first switching device ($Q_1$) is closed;
calculating a first test value of the resistor ($R_{PV+}$) of the positive terminal (PV+) relative to ground and a first test value of the resistor ($R_{PV-}$) of the negative terminal (PV-) relative to ground based on the first node voltage, the first positive voltage, the second node voltage and the second positive voltage;
disconnecting the ground wire (PE) from the common node (1), and connecting the common node (1) with the zero line (N);
obtaining a third node voltage of the common node (1) and a third positive voltage of the positive terminal (PV+) when the first switching device ($Q_1$) is open, and obtaining a fourth node voltage of the common node (1) and a fourth positive voltage of the positive terminal (PV+) when the first switching device ($Q_1$) is closed;
calculating a second test value of the resistor ($R_{PV+}$) of the positive terminal (PV+) relative to ground and a second test value of the resistor ($R_{PV-}$) of the negative terminal (PV-) relative to ground based on the third node voltage, the third positive voltage, the fourth node voltage and the fourth positive voltage;
determining that the ground wire (PE) and the zero line (N) each are grounded effectively, in the case that an absolute value of a difference between the first test value and the second test value of the resistor ($R_{PV+}$) of the positive terminal (PV+) relative to ground is less than a first threshold and an absolute value of a difference between the first test value and the second value of the resistor ($R_{PV-}$) of the negative terminal (PV-) relative to ground is less than the first threshold; and
determining whether the first test value and the second test value of the resistor ($R_{PV+}$) of the positive terminal (PV+) relative to ground each are greater than a second threshold, in the case that the ground wire (PE) and the zero line (N) each are grounded effectively; and determining that the photovoltaic module is normally insulated against ground, if it is determined that the first test value and the second test value of the resistor ($R_{PV+}$) of the positive terminal (PV+) relative to ground each are greater than the second threshold; determining that the photovoltaic module is abnormally insulated against ground if it is determined that the first test value or the second test value of the resistor ($R_{PV+}$) of the positive terminal (PV+) relative to ground is not greater than the second threshold.

8. The detection method according to claim 7, wherein the first threshold is less than or equal to 200$\Omega$.

9. The detection method according to claim 7, wherein the second threshold is greater than or equal to 1K$\Omega$.

**EP 2 975 720 B1**

10. A photovoltaic grid-connected power generation system, comprising at least one detection device for detecting insulation of a photovoltaic module against ground according to any one of claims 1 to 6.

**Patentansprüche**

1. Erfassungsvorrichtung zur Erfassung der Isolierung eines Photovoltaikmoduls gegen Masse, **dadurch gekennzeichnet, dass** es umfasst:

einen ersten Testwiderstand ($R_1$), wobei der erste Testwiderstand ($R_1$) parallel zu einem Widerstand ($R_{PV+}$) eines positiven Anschlusses (PV+) des Photovoltaikmoduls relativ zu Masse verbindbar ist;

einen zweiten Testwiderstand ($R_2$), wobei der zweite Testwiderstand ($R_2$) parallel zu einem Widerstand ($R_{PV-}$) eines negativen Anschlusses (PV-) des Photovoltaikmoduls relativ zu Masse verbindbar ist und ein Ende des zweiten Testwiderstands ($R_2$) mit dem negativen Anschluss (PV-) verbindbar ist und das andere Ende des zweiten Testwiderstands ($R_2$) über den ersten Testwiderstand ($R_1$) mit dem positiven Anschluss (PV+) verbindbar ist;

einen in Reihe geschalteten Zweig aus einem dritten Testwiderstand ($R_3$) und einer ersten Schaltvorrichtung ($Q_1$), wobei der in Reihe geschaltete Zweig mit dem ersten oder zweiten Testwiderstand ($R_1$, $R_2$) parallel geschaltet ist;

eine zweite Schaltvorrichtung (K), wobei die zweite Schaltvorrichtung (K) einen ersten Schaltzustand hat, in dem ein gemeinsamer Knoten (1) zwischen dem ersten Testwiderstand ($R_1$) und dem zweiten Testwiderstand ($R_2$) mit/von einer Masseleitung (PE) eines photovoltaischen Wechselrichters verbunden/getrennt ist, und einen zweiten Schaltzustand, in dem der gemeinsame Knoten (1) mit/von einer Null-Leitung (N) eines Netzes verbunden/getrennt ist; und

ein Steuerungssystem, das konfiguriert ist, um:

den gemeinsamen Knoten (1) mit der Masseleitung (PE) zu verbinden und die Null-Leitung (N) vom gemeinsamen Knoten (1) zu trennen;

eine erste Knotenspannung des gemeinsamen Knotens (1) und eine erste positive Spannung des positiven Anschlusses (PV+) zu erhalten, wenn die erste Schaltvorrichtung ($Q_1$) offen ist, und eine zweite Knotenspannung des gemeinsamen Knotens (1) und eine zweite positive Spannung des positiven Anschlusses (PV+) zu erhalten, wenn die erste Schaltvorrichtung ($Q_1$) geschlossen ist;

einen ersten Testwert des Widerstands ($R_{PV+}$) des positiven Anschlusses (PV+) relativ zu Masse und einen ersten Testwert des Widerstands ($R_{PV-}$) des negativen Anschlusses (PV-) relativ zu Masse auf der Grundlage der ersten Knotenspannung, der ersten positiven Spannung, der zweiten Knotenspannung und der zweiten positiven Spannung zu erhalten;

die Masseleitung (PE) vom gemeinsamen Knoten (1) zu trennen und den gemeinsamen Knoten (1) mit der Null-Leitung (N) zu verbinden;

eine dritte Knotenspannung des gemeinsamen Knotens (1) und eine dritte positive Spannung des positiven Anschlusses (PV+) zu erhalten, wenn die erste Schaltvorrichtung ($Q_1$) offen ist, und eine vierte Knotenspannung des gemeinsamen Knotens (1) und eine vierte positive Spannung des positiven Anschlusses (PV+) zu erhalten, wenn die erste Schaltvorrichtung ($Q_1$) geschlossen ist;

einen zweiten Testwerts des Widerstands ($R_{PV+}$) des positiven Anschlusses (PV+) relativ zu Masse und einen zweiten Testwert des Widerstands ($R_{PV-}$) des negativen Anschlusses (PV-) relativ zu Masse auf der Grundlage der dritten Knotenspannung, der dritten positiven Spannung, der vierten Knotenspannung und der vierten positiven Spannung zu berechnen;

festzustellen, dass die Masseleitung (PE) und die Null-Leitung (N) jeweils effektiv geerdet sind, wenn ein Absolutwert einer Differenz zwischen dem ersten Testwert und dem zweiten Testwert des Widerstands ($R_{PV+}$) des positiven Anschlusses (PV+) relativ zu Masse kleiner als ein erster Schwellenwert ist und ein Absolutwert einer Differenz zwischen dem ersten Testwert und dem zweiten Wert des Widerstands ($R_{PV-}$) des negativen Anschlusses (PV-) relativ zu Masse kleiner als der erste Schwellenwert ist, und

zu bestimmen, ob der erste Testwert und der zweite Testwert des Widerstands ($R_{PV+}$) des positiven Anschlusses (PV+) relativ zu Masse jeweils größer als ein zweiter Schwellenwert sind, für den Fall, dass die Masseleitung (PE) und die Null-Leitung (N) jeweils effektiv geerdet sind; und

festzustellen, dass das Photovoltaikmodul normal gegen Masse isoliert ist, wenn festgestellt wird, dass der erste Testwert und der zweite Testwert des Widerstands ($R_{PV+}$) des positiven Anschlusses (PV+) relativ zu Masse jeweils größer als der zweite Schwellenwert sind; festzustellen, dass das Photovoltaikmodul anormal gegen Masse isoliert ist, wenn festgestellt wird, dass der erste Testwert oder der zweite Testwert

10

des Widerstands ($R_{PV+}$) des positiven Anschlusses (PV+) relativ zu Masse nicht größer als der zweite Schwellenwert ist.

2. Die Erfassungsvorrichtung nach Anspruch 1, ferner umfassend einen Schutzwiderstand ($R_4$), wobei der Schutzwiderstand (R4) zwischen dem gemeinsamen Knoten (1) und der zweiten Schaltvorrichtung (K) angeordnet ist.

3. Die Erfassungsvorrichtung nach Anspruch 1, wobei die zweite Schaltvorrichtung (K) einen ersten Unterschalter ($Q_2$) und einen zweiten Unterschalter ($Q_3$) umfasst,
wobei der erste Unterschalter ($Q_2$) konfiguriert ist, um die Verbindung des gemeinsamen Knotens (1) und der Masseleitung (PE) zu steuern, und der zweite Unterschalter ($Q_3$) konfiguriert ist, um die Verbindung des gemeinsamen Knotens (1) und der Null-Leitung (N) zu steuern.

4. Die Erfassungsvorrichtung nach Anspruch 3, wobei der erste Unterschalter ($Q_2$) ein Transistorschalter, ein mechanischer elektrischer Schalter oder ein Relais ist, und der zweite Unterschalter ($Q_3$) ein Transistorschalter, ein mechanischer elektrischer Schalter oder ein Relais ist.

5. Die Erfassungsvorrichtung nach Anspruch 1, wobei die zweite Schalteinrichtung (K) ein Zweistellungs-Knopfschalter oder ein zweipoliger Umschalter ist.

6. Die Erfassungsvorrichtung nach einem der Ansprüche 1 bis 5, wobei die erste Schaltvorrichtung ($Q_1$) ein Transistorschalter, ein mechanischer Schalter oder ein Relais ist.

7. Ein Erfassungsverfahren zum Erfassen der Isolation eines photovoltaischen Moduls gegen Masse, **dadurch gekennzeichnet, dass** die Erfassungsvorrichtung nach einem der Ansprüche 1 bis 6 zum Erfassen der Isolation des photovoltaischen Moduls gegen Masse verwendet wird, und das Erfassungsverfahren umfasst:

Verbinden des gemeinsamen Knotens (1) mit der Masseleitung (PE) und Trennen der Nullleitung (N) vom gemeinsamen Knoten (1);
Erhalten einer ersten Knotenspannung des gemeinsamen Knotens (1) und einer ersten positiven Spannung des positiven Anschlusses (PV+), wenn die erste Schaltvorrichtung ($Q_1$) offen ist, und Erhalten einer zweiten Knotenspannung des gemeinsamen Knotens (1) und einer zweiten positiven Spannung des positiven Anschlusses (PV+), wenn die erste Schaltvorrichtung ($Q_1$) geschlossen ist;
Berechnen eines ersten Testwertes des Widerstandes ($R_{PV+}$) des positiven Anschlusses (PV+) relativ zu Masse und eines ersten Testwertes des Widerstandes (M) des negativen Anschlusses (PV-) relativ zu Masse auf der Grundlage der ersten Knotenspannung, der ersten positiven Spannung, der zweiten Knotenspannung und der zweiten positiven Spannung;
Trennen der Masseleitung (PE) vom gemeinsamen Knoten (1) und Verbinden des gemeinsamen Knotens (1) mit der Null-Leitung (N);
Erhalten einer dritten Knotenspannung des gemeinsamen Knotens (1) und einer dritten positiven Spannung des positiven Anschlusses (PV+), wenn die erste Schaltvorrichtung ($Q_1$) offen ist, und Erhalten einer vierten Knotenspannung des gemeinsamen Knotens (1) und einer vierten positiven Spannung des positiven Anschlusses (PV+), wenn die erste Schaltvorrichtung ($Q_1$) geschlossen ist;
Berechnen eines zweiten Testwertes des Widerstandes ($R_{PV+}$) des positiven Anschlusses (PV+) relativ zu Masse und eines zweiten Testwertes des Widerstandes ($R_{PV-}$) des negativen Anschlusses (PV-) relativ zu Masse auf der Grundlage der dritten Knotenspannung, der dritten positiven Spannung, der vierten Knotenspannung und der vierten positiven Spannung;
Bestimmen, dass die Masseleitung (PE) und die Null-Leitung (N) jeweils effektiv geerdet sind, wenn ein Absolutwert einer Differenz zwischen dem ersten Testwert und dem zweiten Testwert des Widerstands ($R_{PV+}$) des positiven Anschlusses (PV+) relativ zu Masse kleiner als ein erster Schwellenwert ist, und ein Absolutwert einer Differenz zwischen dem ersten Testwert und dem zweiten Wert des Widerstands ($R_{PV-}$) des negativen Anschlusses (PV-) relativ zu Masse kleiner als der erste Schwellenwert ist; und
Bestimmen, ob der erste Testwert und der zweite Testwert des Widerstands ($R_{PV+}$) des positiven Anschlusses (PV+) relativ zu Masse jeweils größer als ein zweiter Schwellenwert sind, für den Fall, dass die Masseöeitung (PE) und die Null-Leitung (N) jeweils effektiv geerdet sind; und
Feststellen, dass das Photovoltaikmodul normal gegen Masse isoliert ist, wenn festgestellt wird, dass der erste Testwert und der zweite Testwert des Widerstands ($R_{PV+}$) des positiven Anschlusses (PV+) relativ zu Masse jeweils größer als der zweite Schwellenwert sind;
Feststelleng, dass das Photovoltaikmodul nicht ordnungsgemäß gegen Masse isoliert ist, wenn festgestellt wird, dass der erste Testwert oder der zweite Testwert des Widerstands ($R_{PV+}$) des positiven Anschlusses (PV+) gegenüber Masse nicht größer als der zweite Schwellenwert ist.

8. Das Erfassungsverfahren nach Anspruch 7, wobei der erste Schwellenwert kleiner oder gleich 2000 ist.

9. Das Erfassungsverfahren nach Anspruch 7, wobei der zweite Schwellenwert größer oder gleich 1K$\Omega$ ist.

10. Photovoltaisches netzgekoppeltes Stromerzeugungssystem mit mindestens einer Erfassungsvorrichtung zur Erfassung der Isolierung eines photovoltaischen Moduls gegen Masse nach einem der Ansprüche 1 bis 6.

**Revendications**

1. Dispositif de détection pour détecter l'isolation d'un module photovoltaïque contre la masse, **caractérisé en ce qu'**il comprend :

une première résistance de test ($R_1$), dans lequel la première résistance de test ($R_1$) est apte à être connectée en parallèle à une résistance ($R_{PV+}$) d'une borne positive (PV+) du module photovoltaïque par rapport à la masse ;

une deuxième résistance de test ($R_2$), dans lequel la deuxième résistance de test ($R_2$) est apte à être connectée en parallèle à une résistance ($R_{PV-}$) d'une borne négative (PV-) du module photovoltaïque par rapport à la masse, et une extrémité de la deuxième résistance de test ($R_2$) est apte à être connectée à la borne négative (PV-), et l'autre extrémité de la deuxième résistance de test ($R_2$) est apte à être connectée à la borne positive (PV+) via la première résistance de test ($R_1$) ;

une branche en série d'une troisième résistance de test ($R_3$) et d'un premier dispositif de commutation ($Q_1$) connectés en série, dans lequel la branche en série est connectée à la première ou à la deuxième résistance de test ($R_1$, $R_2$) en parallèle ;

un deuxième dispositif de commutation (K), dans lequel le deuxième dispositif de commutation (K) possède un premier état de commutation dans lequel un nœud commun (1) entre la première résistance de test ($R_1$) et la deuxième résistance de test ($R_2$) est connecté/déconnecté avec/d'un fil de masse (PE) d'un onduleur photovoltaïque, et un deuxième état de commutation dans lequel le nœud commun (1) est connecté/déconnecté avec/d'une ligne neutre (N) d'un réseau ; et

un système de commande configuré pour :

connecter le nœud commun (1) au fil de masse (PE), et déconnecter la ligne neutre (N) du nœud commun (1) ;

obtenir une première tension de nœud du nœud commun (1) et une première tension positive de la borne positive (PV+) lorsque le premier dispositif de commutation ($Q_1$) est ouvert, et obtenir une deuxième tension de nœud du nœud commun (1) et une deuxième tension positive de la borne positive (PV+) lorsque le premier dispositif de commutation ($Q_1$) est fermé ;

calculer une première valeur de test de la résistance ($R_{PV+}$) de la borne positive (PV+) par rapport à la masse et une première valeur de test de la résistance ($R_{PV-}$) de la borne négative (PV-) par rapport à la masse sur la base de la première tension de nœud, de la première tension positive, de la deuxième tension de nœud et de la deuxième tension positive ;

déconnecter le fil de masse (PE) du nœud commun (1), et connecter le nœud commun (1) à la ligne neutre (N) ;

obtenir une troisième tension de nœud du nœud commun (1) et une troisième tension positive de la borne positive (PV+) lorsque le premier dispositif de commutation ($Q_1$) est ouvert, et obtenir une quatrième tension de nœud du nœud commun (1) et une quatrième tension positive de la borne positive (PV+) lorsque le premier dispositif de commutation ($Q_1$) est fermé ;

calculer une deuxième valeur de test de la résistance ($R_{PV+}$) de la borne positive (PV+) par rapport à la masse et une deuxième valeur de test de la résistance ($R_{PV-}$) de la borne négative (PV-) par rapport à la masse sur la base de la troisième tension de nœud, de la troisième tension positive, de la quatrième tension de nœud et de la quatrième tension positive ;

déterminer que le fil de masse (PE) et la ligne neutre (N) sont chacun effectivement mis à la masse, dans le cas où une valeur absolue d'une différence entre la première valeur de test et la deuxième valeur de test de la résistance ($R_{PV+}$) de la borne positive (PV+) par rapport à la masse est inférieure à un premier seuil et une valeur absolue d'une différence entre la première valeur de test et la deuxième valeur de test de la résistance ($R_{PV-}$) de la borne négative (PV-) par rapport à la masse est inférieure au premier seuil ; et déterminer si la première valeur de test et la deuxième valeur de test de la résistance ($R_{PV+}$) de la borne positive (PV+) par rapport à la masse sont chacune supérieures à un deuxième seuil, dans le cas où le fil de masse (PE) et la ligne neutre (N) sont chacun effectivement mis à la masse ; et déterminer que le module photovoltaïque est normalement isolé contre la masse, s'il est déterminé que la première valeur de test et la deuxième valeur de test de la résistance ($R_{PV+}$) de la borne positive (PV+) par rapport à la masse sont chacune supérieures au deuxième seuil ; déterminer que le module photovoltaïque est anormalement isolé contre la masse s'il est déterminé que la première valeur de test ou la deuxième valeur de test de la résistance ($R_{PV+}$) de la borne positive (PV+) par rapport à la masse n'est pas supérieure au deuxième seuil.

2. Dispositif de détection selon la revendication 1, comprenant en outre une résistance de protection ($R_4$), dans lequel la résistance de protection ($R_4$) est agencée entre le nœud commun (1) et le deuxième dispositif de commutation (K).

3. Dispositif de détection selon la revendication 1, dans lequel le deuxième dispositif de commutation (K) comprend un premier sous-commutateur ($Q_2$) et un deuxième sous-commutateur ($Q_3$),
dans lequel le premier sous-commutateur (Q2) est configuré pour commander la connexion du nœud commun (1) et du fil de masse (PE), et le deuxième sous-commutateur ($Q_3$) est configuré pour commander la connexion du nœud commun (1) et de la ligne neutre (N).

4. Dispositif de détection selon la revendication 3, dans lequel le premier sous-commutateur ($Q_2$) est un commutateur à transistor, un commutateur électrique mécanique ou un relais, et le deuxième sous-commutateur ($Q_3$) est un commutateur à transistor, un commutateur électrique mécanique ou un relais.

5. Dispositif de détection selon la revendication 1, dans lequel le deuxième dispositif de commutation (K) est un commutateur à bouton à deux positions ou un commutateur bipolaire bidirectionnel.

6. Dispositif de détection selon l'une quelconque des revendications 1 à 5, dans lequel le premier dispositif de commutation ($Q_1$) est un commutateur à transistor, un commutateur mécanique ou un relais.

7. Procédé de détection pour détecter l'isolation d'un module photovoltaïque contre la masse, **caractérisé en ce que** le dispositif de détection selon l'une quelconque des revendications 1 à 6 est adopté pour détecter l'isolation du module photovoltaïque contre la masse, et le procédé de détection comprend :

la connexion du nœud commun (1) au fil de masse (PE), et la déconnexion de la ligne neutre (N) du nœud commun (1) ;
l'obtention d'une première tension de nœud du nœud commun (1) et d'une première tension positive de la borne positive (PV+) lorsque le premier dispositif de commutation ($Q_1$) est ouvert, et l'obtention d'une deuxième tension de nœud du nœud commun (1) et d'une deuxième tension positive de la borne positive (PV+) lorsque le premier dispositif de commutation ($Q_1$) est fermé ;
le calcul d'une première valeur de test de la résistance ($R_{PV+}$) de la borne positive (PV+) par rapport à la masse et d'une première valeur de test de la résistance ($R_{PV-}$) de la borne négative (PV-) par rapport à la masse sur la base de la première tension de nœud, de la première tension positive, de la deuxième tension de nœud et de la deuxième tension positive ;
la déconnexion du fil de masse (PE) du nœud commun (1), et la connexion du nœud commun (1) à la ligne neutre (N) ;
l'obtention d'une troisième tension de nœud du nœud commun (1) et d'une troisième tension positive de la borne positive (PV+) lorsque le premier dispositif de commutation ($Q_1$) est ouvert, et l'obtention d'une quatrième tension de nœud du nœud commun (1) et d'une quatrième tension positive de la borne positive (PV+) lorsque le premier dispositif de commutation ($Q_1$) est fermé ;
le calcul d'une deuxième valeur de test de la résistance ($R_{PV+}$) de la borne positive (PV+) par rapport à la masse et d'une deuxième valeur de test de la résistance ($R_{PV-}$) de la borne négative (PV-) par rapport à la masse sur la base de la troisième tension de nœud, de la troisième tension positive, de la quatrième tension de nœud et de la quatrième tension positive ;
la détermination que le fil de masse (PE) et la ligne neutre (N) sont chacun effectivement mis à la masse, dans le cas où une valeur absolue d'une différence entre la première valeur de test et la deuxième valeur de test de la résistance ($R_{PV+}$) de la borne positive (PV+) par rapport à la masse est inférieure à un premier seuil et une valeur absolue d'une différence entre la première valeur de test et la deuxième valeur de test de la résistance ($R_{PV-}$) de la borne négative (PV-) par rapport à la masse est inférieure au premier seuil ; et

la détermination de si la première valeur de test et la deuxième valeur de test de la résistance ($R_{PV+}$) de la borne positive (PV+) par rapport à la masse sont chacune supérieures à un deuxième seuil, dans le cas où le fil de masse (PE) et la ligne neutre (N) sont chacun effectivement mis à la masse ; et la détermination que le module photovoltaïque est normalement isolé contre la masse, s'il est déterminé que la première valeur de test et la deuxième valeur de test de la résistance ($R_{PV+}$) de la borne positive (PV+) par rapport à la masse sont chacune supérieures au deuxième seuil ; la détermination que le module photovoltaïque est anormalement isolé contre la masse s'il est déterminé que la première valeur de test ou la deuxième valeur de test de la résistance ($R_{PV+}$) de la borne positive (PV+) par rapport à la masse n'est pas supérieure au deuxième seuil.

**8.** Procédé de détection selon la revendication 7, dans lequel le premier seuil est inférieur ou égal à 200$\Omega$.

**9.** Procédé de détection selon la revendication 7, dans lequel le deuxième seuil est supérieur ou égal à 1K$\Omega$.

**10.** Système de génération d'énergie connecté à un réseau photovoltaïque, comprenant au moins un dispositif de détection pour détecter l'isolation d'un module photovoltaïque contre la masse selon l'une quelconque des revendications 1 à 6.

**Figure 1**

**Figure 2**

PV1+

PV2+

PVn+

PV-

Insulation
detection
circuit for a
photovoltaic
array

$R_4$

K

Q2

Q3

PE

N

**Figure 3**

PV1+

PV2+

PVn+

PV-

Insulation
detection
circuit for a
photovoltaic
array

$R_4$

K

PE

N

**Figure 4**

**Figure 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 102967766 A
- WO 2012120683 A1